(19) Europäisches Patentamt / European Patent Office / Office européen des brevets

(11) **EP 4 776 540 A1**

(12) **EUROPEAN PATENT APPLICATION**
published in accordance with Art. 153(4) EPC

(43) Date of publication:
**15.07.2026   Bulletin 2026/29**

(21) Application number: **24870242.5**

(22) Date of filing: **23.08.2024**

(51) International Patent Classification (IPC):
**H04L 1/00** (2006.01)

(52) Cooperative Patent Classification (CPC):
**H03M 13/09; H03M 13/15; H03M 13/29; H04L 1/00**

(86) International application number:
**PCT/CN2024/114145**

(87) International publication number:
**WO 2025/066696 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:   **28.09.2023   CN 202311295101**

(71) Applicant: **HUAWEI TECHNOLOGIES CO., LTD.**
**Shenzhen 518129 (CN)**

(72) Inventors:
• HUANG, Qinhui
  Shenzhen, Guangdong 518129 (CN)
• LI, Jinsheng
  Shenzhen, Guangdong 518129 (CN)
• YANG, Xiaoling
  Shenzhen, Guangdong 518129 (CN)
• MA, Huixiao
  Shenzhen, Guangdong 518129 (CN)

(74) Representative: **Pfenning, Meinig & Partner mbB**
**Patent- und Rechtsanwälte**
**Theresienhöhe 11a**
**80339 München (DE)**

(54) **DATA ENCODING METHOD AND RELATED DEVICE**

(57)     Embodiments of this application provide a data encoding method and a related apparatus, to reduce encoding complexity without changing a length of an inner codeword and redundancy costs. Specifically, for a first data stream obtained through outer encoding, inner encoding needs to be performed on every consecutive k bits in the first data stream, where k is an odd number greater than 1. A total of (k-1)/2 bits may be obtained by performing an exclusive OR operation on every two of remaining bits other than one target bit in the k bits. Further, second FEC encoding is performed on a bit sequence that includes the (k-1)/2 bits and the target bit, to obtain p parity bits. n bits in an inner codeword obtained through inner encoding include the consecutive k bits and the p parity bits. It can be learned that, in embodiments of this application, an exclusive OR operation first and then encoding manner is used. For example, (128, 119) codeword processing may be implemented via a (69, 60) encoder, so that encoding complexity is reduced without changing a length of the inner codeword and redundancy costs.

FIG. 5

## Description

This application claims priority to Chinese Patent Application No. 202311295101.1, filed with the China National Intellectual Property Administration on September 28, 2023 and entitled "DATA ENCODING METHOD AND RELATED APPARATUS", which is incorporated herein by reference in its entirety.

## TECHNICAL FIELD

Embodiments of this application relate to the field of optical communication, and in particular, to a data encoding method and a related apparatus.

## BACKGROUND

Driven by continuous advancement of 5G, cloud computing, big data, artificial intelligence, and the like, optical communication systems and optical transport networks (optical transport networks, OTN) are evolving toward large capacity and ultra-high speeds. Forward error correction (forward error correction, FEC) encoding is used to correct transmission bit errors, so that original data sent from a transmitter can be recovered from received data.

In a 400G ZR scenario, an optical module uses CFEC (Concatenated-FEC) as an error correction encoding scheme, which includes a staircase code as an outer code, and a double-bit extended Hamming (hamming) code as an inner code. In a future 1.6T ZR scenario, due to a significant increase in transmission rates, power consumption issues faced by existing CFEC schemes become more severe, and an encoding and decoding scheme with lower power consumption is urgently needed.

## SUMMARY

Embodiments of this application provide a data encoding method and a related apparatus, to reduce encoding complexity without changing a length of an inner codeword and redundancy costs.

According to a first aspect, an embodiment of this application provides a data encoding method. Specifically, consecutive k bits in a first data stream obtained through first forward error correction (forward error correction, FEC) encoding are first obtained, and the first FEC encoding may be considered as outer encoding. k is an odd number greater than 1, the consecutive k bits include a bit set and a target bit, the bit set includes (k-1)/2 bit subsets, and each bit subset includes two bits. Then, inner encoding is performed on the consecutive k bits to obtain a codeword. A specific operation of the inner encoding is as follows: first, performing an exclusive OR operation on the two bits in each bit subset to obtain one bit, to obtain a total of (k-1)/2 bits; and then, performing second FEC encoding on a bit sequence that includes the (k-1)/2 bits and the target bit, to obtain p parity bits. The codeword obtained through inner encoding includes the consecutive k bits and the p parity bits, where p is an integer greater than or equal to 1.

In this implementation, for a first data stream obtained through outer encoding, inner encoding needs to be performed on every consecutive k bits in the first data stream, where k is an odd number greater than 1. Specifically, a total of (k-1)/2 bits may be obtained by performing an exclusive OR operation on every two of remaining bits other than one target bit in the k bits. Further, second FEC encoding is performed on the bit sequence that includes the (k-1)/2 bits and the target bit, to obtain the p parity bits. n bits in an inner codeword obtained through inner encoding include the consecutive k bits and the p parity bits. It can be learned that, in embodiments of this application, an exclusive OR operation first and then encoding manner is used. For example, (128, 119) codeword processing may be implemented via a (69, 60) encoder, so that encoding complexity is reduced without changing a length of the inner codeword and redundancy costs.

In some possible implementations, the two bits in each bit subset are two adjacent bits in the consecutive k bits, and selecting the two adjacent bits to perform an exclusive OR operation is easier to implement, thereby facilitating standardization.

In some possible implementations, the p parity bits are located after the consecutive k bits in the codeword, and the target bit is a last bit in the consecutive k bits; or the p parity bits are located before the consecutive k bits in the codeword, and the target bit is a 1st bit in the consecutive k bits. In other words, the 1st bit or the last bit in an information sequence of the k bits is selected as the target bit, and a parity sequence of the p parity bits is arranged close to the target bit. This is more conducive to distribution of the information sequence and the parity sequence in the inner codeword.

In some possible implementations, after performing inner encoding on the consecutive k bits to obtain the codeword, the method further includes: performing symbol mapping and polarization distribution on eight bits from four bit subsets in a second data stream that includes at least one codeword to obtain one dual-polarization (Dual-polarization, DP)-16QAM symbol, where the four bit subsets are respectively mapped, through Gray mapping, to an I component in an X polarization direction, a Q component in the X polarization direction, an I component in a Y polarization direction, and a Q component in the Y polarization direction that are of the DP-16QAM symbol. In other words, any component of the DP-16QAM symbol is obtained by performing Gray mapping on two bits of one bit subset participating in the exclusive OR operation. Therefore, generally, at most one error bit occurs in two bits mapped to a same PAM4 symbol, thereby reducing a likelihood of an error bit.

In some possible implementations, the second FEC encoding is BCH encoding or extended BCH encoding over a finite field GF($2^m$) with t-bit error correction, to enrich encoding modes that may be used for the inner encoding. Mt $\leq$ p, and

$$\frac{k+1}{2} + p \leq 2^m - 1$$, that is, a value of m in GF($2^m$) is not unique. For example, if the value of m is subtracted by 1 based on an original value, a quantity of parity bits may be reduced by t when encoding is performed in this manner, so that a bit rate of the codeword is increased and overheads of the codeword are reduced when a length of information bits is unchanged.

In some possible implementations, k=119, and GF($2^m$) used in the second FEC encoding is GF($2^8$) or GF($2^7$). In a scenario in which k=119, implementability of the inner encoding is improved.

In some possible implementations, a length of the codeword is n, the second FEC encoding is the BCH encoding over GF($2^m$) with t-bit error correction, and a correspondence among n, k, GF($2^m$), t, and p is one of the following:

n=133, k=119, GF($2^m$)= GF($2^7$), t=2, and p=14; and
n=135, k=119, GF($2^m$)= GF($2^8$), t=2, and p=16.

In some possible implementations, a length of the codeword is n, the second FEC encoding is the extended BCH encoding over the finite field GF($2^m$) with t-bit error correction, the p parity bits include a cyclic redundancy check (cyclic redundancy check, CRC) extended check field of q bits, and a correspondence among n, k, GF($2^m$), t, p, and q is one of the following:

n=128, k=119, GF($2^m$)=GF($2^7$), t=1, p=9, and q=2;
n=134, k=119, GF($2^m$)= GF($2^7$), t=2, p=15, and q=1;
n=135, k=119, GF($2^m$)= GF($2^7$), t=2, p=16, and q=2;
n=136, k=119, GF($2^m$)= GF($2^8$), t=2, p=17, and q=1; and
n=137, k=119, GF($2^m$)= GF($2^8$), t=2, p=18, and q=2.

According to a second aspect, an embodiment of this application provides a data encoding method. Specifically, consecutive k bits in a first data stream obtained through first FEC encoding is performed, and the first FEC encoding may be considered as outer encoding. k is an integer greater than or equal to 3, the consecutive k bits include v bit subsets, each bit subset includes three bits, and v is an integer greater than or equal to 1. Then, inner encoding is performed on the consecutive k bits to obtain a codeword. A specific operation of the inner encoding is as follows: first, performing an exclusive OR operation on the three bits in each bit subset to obtain one bit, to obtain a total of v bits; and then, performing second FEC encoding on a bit sequence that includes the v bits, to obtain p parity bits. The codeword obtained through inner encoding includes the consecutive k bits and the p parity bits, where p is an integer greater than or equal to 1.

In this implementation, for a first data stream obtained through outer encoding, inner encoding needs to be performed on every consecutive k bits in the first data stream, where k is an odd number greater than 1. Specifically, an exclusive OR operation is performed on every three bits in the k bits to obtain a total of v bits. Further, second FEC encoding is performed on the v bits, to obtain the p parity bits. n bits in an inner codeword obtained through inner encoding include the consecutive k bits and the p parity bits. It can be learned that, in embodiments of this application, an exclusive OR operation first and then encoding manner is used. For example, (128, 119) codeword processing may be implemented via a (50, 41) encoder, so that encoding complexity is reduced without changing a length of the inner codeword and redundancy costs.

In some possible implementations, the three bits in each bit subset are consecutive three bits in the consecutive k bits, and selecting every consecutive three bits to perform an exclusive OR operation is easier to implement, thereby facilitating standardization.

In some possible implementations, k=v×3, that is, an exclusive OR operation may be performed on exactly every three bits in the k bits, and this has good practicability.

In some possible implementations, the consecutive k bits further include r target bits, where k=v×3+r, and r=1 or 2. Performing second FEC encoding on the bit sequence that includes the v bits to obtain the p parity bits includes: performing second FEC encoding on the bit sequence that includes the v bits and the r target bits, to obtain the p parity bits. In other words, this scheme may also be applied to a scenario in which k is not divisible by 3, thereby expanding scope of application scenarios of this scheme.

In some possible implementations, the p parity bits are located after the consecutive k bits in the codeword, and the target bits are last r bits in the consecutive k bits; or the p parity bits are located before the consecutive k bits in the codeword, and the target bits are first r bits in the consecutive k bits. In other words, the first r bits or the last r bits in an information sequence of the k bits are selected as the target bits, and a parity sequence of the p parity bits is arranged close to the target bit. This is more conducive to distribution of the information sequence and the parity sequence in the inner codeword.

In some possible implementations, after performing inner encoding on the consecutive k bits to obtain the codeword, the method further includes: performing symbol mapping and polarization distribution on 12 bits from four bit subsets in a second data stream that includes at least one codeword to obtain one DP-64QAM symbol, where the four bit subsets are respectively mapped, through Gray mapping, to an I component in an X polarization direction, a Q component in the X polarization direction, an I component in a Y polarization direction, and a Q component in the Y polarization direction that are of the DP-64QAM symbol, and the X polarization direction and the Y polarization direction are orthogonal to each other. In other words, any component of the DP-64QAM symbol is obtained by performing Gray mapping on three bits of one bit subset participating in the exclusive OR operation. Therefore, generally, at most one error bit occurs in three bits mapped to a same PAM8 symbol, thereby reducing a likelihood of an error bit.

In some possible implementations, the second FEC encoding is BCH encoding or extended BCH encoding over a finite field $GF(2^m)$ with t-bit error correction, to enrich encoding modes that may be used for the inner encoding. $mt \leq p$, and $v + r \leq 2^m - 1 - p$, that is, a value of m in $GF(2^m)$ is not unique. For example, if the value of m is subtracted by 1 based on an original value, a quantity of parity bits may be reduced by t when encoding is performed in this manner, so that a bit rate of the codeword is increased and overheads of the codeword are reduced when a length of information bits is unchanged.

In some possible implementations, k=119, and $GF(2^m)$ used in the second FEC encoding is $GF(2^8)$, $GF(2^7)$, or $GF(2^6)$. In a scenario in which k=119, implementability of the inner encoding is improved.

In some possible implementations, a length of the codeword is n, the second FEC encoding is the BCH encoding over $GF(2^m)$ with t-bit error correction, and a correspondence among n, k, $GF(2^m)$, t, and p is one of the following:

n=131, k=119, $GF(2^m)$= $GF(2^6)$, t=2, and p=12;
n=133, k=119, $GF(2^m)$= $GF(2^7)$, t=2, and p=14; and
n=135, k=119, $GF(2^m)$= $GF(2^8)$, t=2, and p=16.

In some possible implementations, a length of the codeword is n, the second FEC encoding is the extended BCH encoding over the finite field $GF(2^m)$ with t-bit error correction, the p parity bits include a cyclic redundancy check CRC extended check field of q bits, and a correspondence among n, k, $GF(2^m)$, t, p, and q is one of the following:

n=127, k=119, $GF(2^m)$= $GF(2^6)$, t=1, p=8, and q=2;
n=128, k=119, $GF(2^m)$= $GF(2^7)$, t=1, p=9, and q=2;
n=132, k=119, $GF(2^m)$= $GF(2^6)$, t=2, p=13, and q=1;
n=133, k=119, $GF(2^m)$= $GF(2^6)$, t=2, p=14, and q=2;
n=134, k=119, $GF(2^m)$= $GF(2^7)$, t=2, p=15, and q=1;
n=135, k=119, $GF(2^m)$= $GF(2^7)$, t=2, p=16, and q=2;
n=136, k=119, $GF(2^m)$= $GF(2^8)$, t=2, p=17, and q=1; and
n=137, k=119, $GF(2^m)$= $GF(2^8)$, t=2, p=18, and q=2.

According to a third aspect, an embodiment of this application provides a data encoding apparatus. The data encoding apparatus includes an obtaining unit and an encoding unit. The obtaining unit is configured to: obtain consecutive k bits in a first data stream obtained through first FEC encoding, where k is an odd number greater than 1, the consecutive k bits include a bit set and a target bit, the bit set includes (k-1)/2 bit subsets, and each bit subset includes two bits; and the encoding unit is configured to: perform inner encoding on the consecutive k bits to obtain a codeword, where the encoding unit is specifically configured to: perform an exclusive OR operation on the two bits in each bit subset to obtain one bit, to obtain a total of (k-1)/2 bits; and perform second FEC encoding on a bit sequence that includes the (k-1)/2 bits and the target bit, to obtain p parity bits. The codeword obtained through inner encoding includes the consecutive k bits and the p parity bits, where p is an integer greater than or equal to 1.

In some possible implementations, the two bits in each bit subset are two adjacent bits in the consecutive k bits.

In some possible implementations, the p parity bits are located after the consecutive k bits in the codeword, and the target bit is a last bit in the consecutive k bits; or the p parity bits are located before the consecutive k bits in the codeword, and the target bit is a 1st bit in the consecutive k bits.

In some possible implementations, the data encoding apparatus further includes a mapping unit, and the mapping unit is configured to: perform symbol mapping and polarization distribution on eight bits from four bit subsets in a second data stream that includes at least one codeword to obtain one DP-16QAM symbol, where the four bit subsets are respectively mapped to an I component in an X polarization direction, a Q component in the X polarization direction, an I component in a Y polarization direction, and a Q component in the Y polarization direction that are of the DP-16QAM symbol, and the X polarization direction and the Y polarization direction are orthogonal to each other.

In some possible implementations, the second FEC encoding is BCH encoding or extended BCH encoding over GF($2^m$) with t-bit error correction, where both m and t are integers greater than or equal to 1, mt $\leq$ p, and

$$\frac{k+1}{2} + p \leq 2^m - 1$$

.

In some possible implementations, k=119, and GF($2^m$) used in the second FEC encoding is GF($2^8$) or GF($2^7$).

In some possible implementations, a length of the codeword is n, the second FEC encoding is the BCH encoding over GF($2^m$) with t-bit error correction, and a correspondence among n, k, GF($2^m$), t, and p is one of the following:

> n=133, k=119, GF($2^m$)= GF($2^7$), t=2, and p=14; and
> n=135, k=119, GF($2^m$)= GF($2^8$), t=2, and p=16.

In some possible implementations, a length of the codeword is n, the second FEC encoding is the extended BCH encoding over the finite field GF($2^m$) with t-bit error correction, the p parity bits include a cyclic redundancy check CRC extended check field of q bits, and a correspondence among n, k, GF($2^m$), t, p, and q is one of the following:

> n=128, k=119, GF($2^m$)=GF($2^7$), t=1, p=9, and q=2;
> n=134, k=119, GF($2^m$)= GF($2^7$), t=2, p=15, and q=1;
> n=135, k=119, GF($2^m$)= GF($2^7$), t=2, p=16, and q=2;
> n=136, k=119, GF($2^m$)= GF($2^8$), t=2, p=17, and q=1; and
> n=137, k=119, GF($2^m$)= GF($2^8$), t=2, p=18, and q=2.

According to a fourth aspect, an embodiment of this application provides a data encoding apparatus. The data encoding apparatus includes an obtaining unit and an encoding unit. The obtaining unit is configured to: obtain consecutive k bits in a first data stream obtained through first FEC encoding, where k is an integer greater than or equal to 3, the consecutive k bits include v bit subsets, each bit subset includes three bits, and v is an integer greater than or equal to 1; and the encoding unit is configured to: perform inner encoding on the consecutive k bits to obtain a codeword, where the encoding unit is specifically configured to: perform an exclusive OR operation on the three bits in each bit subset to obtain one bit, to obtain a total of v bits; and perform second FEC encoding on a bit sequence that includes the v bits, to obtain p parity bits. The codeword obtained through inner encoding includes the consecutive k bits and the p parity bits, where p is an integer greater than or equal to 1.

In some possible implementations, the three bits in each bit subset are consecutive three bits in the consecutive k bits.

In some possible implementations, k=v$\times$3.

In some possible implementations, the consecutive k bits further include r target bits, where k=v$\times$3+r, and r=1 or 2, and the encoding unit is specifically configured to: perform second FEC encoding on the bit sequence that includes the v bits and the r target bits, to obtain the p parity bits.

In some possible implementations, the p parity bits are located after the consecutive k bits in the codeword, and the target bits are last r bits in the consecutive k bits; or the p parity bits are located before the consecutive k bits in the codeword, and the target bits are first r bits in the consecutive k bits.

In some possible implementations, the data encoding apparatus further includes a mapping unit, and the mapping unit is configured to: perform symbol mapping and polarization distribution on 12 bits from four bit subsets in a second data stream that includes at least one codeword to obtain one DP-64QAM symbol, where the four bit subsets are respectively mapped to an I component in an X polarization direction, a Q component in the X polarization direction, an I component in a Y polarization direction, and a Q component in the Y polarization direction that are of the DP-64QAM symbol, and the X polarization direction and the Y polarization direction are orthogonal to each other.

In some possible implementations, the second FEC encoding is BCH encoding or extended BCH encoding over GF($2^m$) with t-bit error correction, where both m and t are integers greater than or equal to 1, mt $\leq$ p, and v + r $\leq 2^m$ - 1 - p.

In some possible implementations, k=119, and GF($2^m$) used in the second FEC encoding is GF($2^8$), GF($2^7$), or GF($2^6$).

In some possible implementations, a length of the codeword is n, the second FEC encoding is the BCH encoding over GF($2^m$) with t-bit error correction, and a correspondence among n, k, GF($2^m$), t, and p is one of the following:

> n=131, k=119, GF($2^m$)= GF($2^6$), t=2, and p=12;
> n=133, k=119, GF($2^m$)= GF($2^7$), t=2, and p=14; and
> n=135, k=119, GF($2^m$)= GF($2^8$), t=2, and p=16.

In some possible implementations, a length of the codeword is n, the second FEC encoding is the extended BCH encoding over the finite field GF($2^m$) with t-bit error correction, the p parity bits include a cyclic redundancy check CRC extended check field of q bits, and a correspondence among n, k, GF($2^m$), t, p, and q is one of the following:

n=127, k=119, GF($2^m$)= GF($2^6$), t=1, p=8, and q=2;
n=128, k=119, GF($2^m$)= GF($2^7$), t=1, p=9, and q=2;
n=132, k=119, GF($2^m$)= GF($2^6$), t=2, p=13, and q=1;
n=133, k=119, GF($2^m$)= GF($2^6$), t=2, p=14, and q=2;
n=134, k=119, GF($2^m$)= GF($2^7$), t=2, p=15, and q=1;
n=135, k=119, GF($2^m$)= GF($2^7$), t=2, p=16, and q=2;
n=136, k=119, GF($2^m$)= GF($2^8$), t=2, p=17, and q=1; and
n=137, k=119, GF($2^m$)= GF($2^8$), t=2, p=18, and q=2.

According to a fifth aspect, an embodiment of this application provides a chip. The chip includes a processor and a memory, the memory and the processor are connected to each other through a line, the memory stores instructions, and the processor is configured to perform the method described in any one of the implementations of the first aspect and the second aspect.

According to a sixth aspect, an embodiment of this application provides a data transmission system. The data transmission system includes a data sending device and a data receiving device. The data sending device is configured to: perform the method described in any one of the implementations of the first aspect and the second aspect and send data to the data receiving device. The data receiving device is configured to perform an operation like decoding on the received data.

According to a seventh aspect, an embodiment of this application provides a computer-readable storage medium, where the computer-readable storage medium stores a computer program, and when the computer program is executed by a computer, the method described in any one of the implementations of the first aspect and the second aspect is implemented.

**BRIEF DESCRIPTION OF DRAWINGS**

FIG. 1 is a diagram of a communication system to which an embodiment of this application is applied;
FIG. 2 is a diagram of another communication system to which an embodiment of this application is applied;
FIG. 3 is a schematic flowchart of a data encoding method according to an embodiment of this application;
FIG. 4(a) is a diagram of an implementation of performing an exclusive OR operation on every two bits according to an embodiment of this application;
FIG. 4(b) is a diagram of another implementation of performing an exclusive OR operation on every two bits according to an embodiment of this application;
FIG. 4(c) is a diagram of an implementation of performing an exclusive OR operation on every three bits according to an embodiment of this application;
FIG. 5 is a diagram of an implementation of inner encoding according to an embodiment of this application;
FIG. 6 is a diagram of a first application scenario of inner encoding according to an embodiment of this application;
FIG. 7 is a diagram of a second application scenario of inner encoding according to an embodiment of this application;
FIG. 8 is a diagram of a third application scenario of inner encoding according to an embodiment of this application;
FIG. 9 is a diagram of a fourth application scenario of inner encoding according to an embodiment of this application;
FIG. 10 is a diagram of a fifth application scenario of inner encoding according to an embodiment of this application;
FIG. 11 is a diagram of a sixth application scenario of inner encoding according to an embodiment of this application;
FIG. 12 is a diagram of a seventh application scenario of inner encoding according to an embodiment of this application;
FIG. 13 is a diagram of a structure of a data encoding apparatus according to an embodiment of this application; and
FIG. 14 is a diagram of another structure of a data encoding apparatus according to an embodiment of this application.

**DESCRIPTION OF EMBODIMENTS**

Embodiments of this application provide a data encoding method and a related apparatus, to reduce encoding complexity without changing a length of an inner codeword and redundancy costs. It should be noted that in the specification, claims, and the foregoing accompanying drawings of this application, the terms "first", "second", and the like are intended to distinguish similar objects but do not limit a specific order or sequence. It should be understood that the foregoing terms may be interchanged in proper cases, so that embodiments described in this application can be implemented in other orders than the order in the content described in this application. In addition, the terms "include", "have", and any other variant thereof are intended to cover a non-exclusive inclusion. For example, a process, method, system, product, or device that includes a list of steps or units is not necessarily limited to those expressly enumerated steps or units, but may include other steps or units not expressly enumerated or inherent to such a process, method, product, or device.

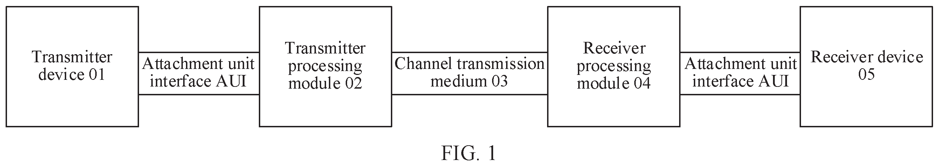

FIG. 1 is a diagram of a communication system to which an embodiment of this application is applied. As shown in FIG. 1, the communication system includes a transmitter device 01, a transmitter processing module 02, a channel transmission medium 03, a receiver processing module 04, and a receiver device 05. For example, the communication system is a data center network. The transmitter device 01 and the receiver device 05 may be devices such as a switch or a router, the transmitter device 01 is also referred to as a host chip (host chip) located at a transmitter, the receiver device 05 is also referred to as a host chip located at a receiver, and the channel transmission medium 03 may be an optical fiber. The host chip is also sometimes referred to as a host device (host device). The transmitter device 01 may be connected to the transmitter processing module 02 through an attachment unit interface (attachment unit interface, AUI), and the receiver device 05 may be connected to the receiver processing module 04 through an AUI. The transmitter processing module 02 and the receiver processing module 04 may each be an optical module (optical module), an electrical module, a connector (connector), or another module that processes data in a data sending process. For example, the processing module may be an 800ZR module (800ZR module, which is a coherent optical module). In addition, all the transmitter device 01, the transmitter processing module 02, the channel transmission medium 03, the receiver processing module 04, and the receiver device 05 in the communication system may support bidirectional transmission or unidirectional transmission. This is not specifically limited herein.

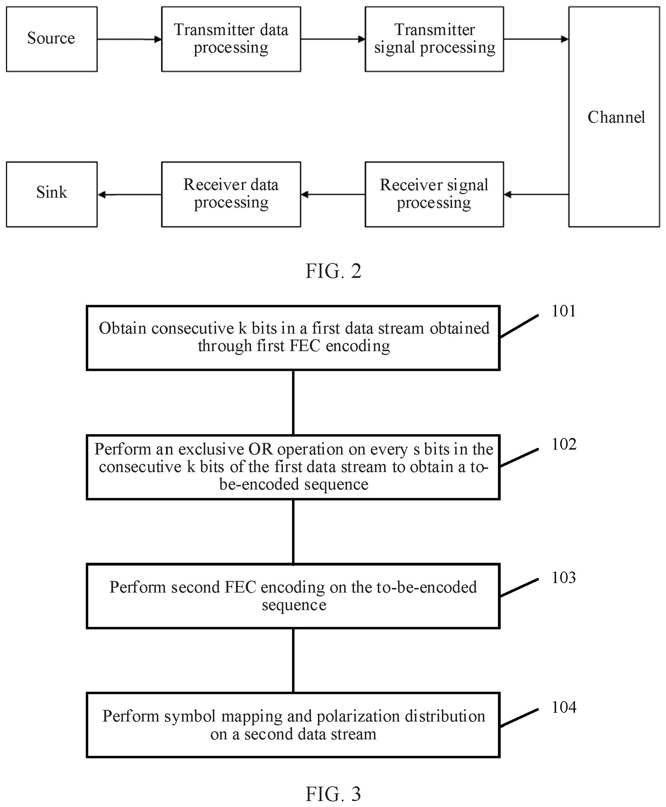

FIG. 2 is a diagram of another communication system to which an embodiment of this application is applied. As shown in FIG. 2, at a transmitter, a source provides a to-be-sent data stream. A transmitter data processor receives the data stream, performs data processing including encoding, interleaving, and modulation on the data stream to obtain a symbol data stream. aThe symbol data stream is then delivered to a transmitter signal processor for framing and is transmitted through a channel to a receiving device. After receiving a signal that is distorted due to noise or other impairments on the channel, the receiving device sends the signal to a receiver signal processor for dispersion compensation, synchronization, phase recovery, and other operations. Then, the signal is sent to the receiver data processing for performing demodulation, deinterleaving, and decoding, to recover original data, and send the data to a sink. Transmitter data processing and transmitter signal processing shown in FIG. 2 may be applied to the transmitter processing module 02 shown in FIG. 1, and receiver data processing and receiver signal processing shown in FIG. 2 may be applied to the receiver processing module 04 shown in FIG. 1.

It should be understood that the "inner" in an inner code and the "outer" in an outer code are distinguished based merely on a distance between an execution body that performs an operation on data and a channel transmission medium. An execution body that performs an operation on the inner code is closer to the channel transmission medium, and an execution body that performs an operation on the outer code is farther away from the channel transmission medium. In embodiments of this application, FIG. 1 is used as an example. Because the transmitter processing module 02 sequentially encodes data twice and then sends the encoded data to the channel transmission medium, data that is first encoded by the transmitter processing module 02 is farther away from the channel transmission medium, and data that is later encoded by the transmitter processing module 02 is closer to the channel transmission medium. In this way, the data that is first encoded by the transmitter processing module 02 is referred to as outer encoded data, and the data that is later encoded by the transmitter processing module 02 is referred to as inner encoded data. Correspondingly, data that is first decoded by the receiver processing module 04 is referred to as inner decoded data, and data that is later decoded by the receiver processing module 04 is referred to as outer decoded data. In a possible implementation, both the inner encoding and the outer encoding use an FEC encoding manner, so as to form a concatenated FEC transmission scheme. For example, the transmitter processing module 02 may perform outer encoding by using a staircase code, perform inner encoding by using a Hamming (Hamming) code, or perform inner encoding by using a Bose-Chaudhuri-Hocquenghem (Bose-Chaudhuri-Hocquenghem, BCH) code.

It should be noted that the foregoing content is example description of an application scenario of the data encoding method provided in embodiments of this application, and does not constitute any limitation on application scenarios of the data encoding method. A person of ordinary skill in the art may learn that, as a service requirement changes, the application scenario of the data encoding method may be adjusted based on an application requirement. Application scenarios are not listed one by one in embodiments of this application. The following mainly describes a data encoding method applied to a data transmitter. A data decoding method applied to a receiver may be understood as an inverse operation of the data encoding method. With the encoding method determined, the data decoding method is also clear. Therefore, the data decoding method is not described in detail in this application.

FIG. 3 is a schematic flowchart of a data encoding method according to an embodiment of this application. The data encoding method includes the following steps, which are described in detail below. It should be understood that, for ease of description, first FEC encoding in the following is equivalent to the outer encoding described above. Inner encoding provided in embodiments of this application includes two operations: grouping and exclusive OR and second FEC encoding. The following may be understood based on this.

101: Obtain consecutive k bits in a first data stream obtained through first FEC encoding.

In embodiments of this application, the consecutive k bits in the first data stream are k information bits on which inner encoding is to be performed. It should be understood that, for an inner code, the k information bits on which inner encoding is to be performed may include an information bit and a parity bit in an outer codeword. Considering that the inner encoding is mainly described in embodiments of this application, all information bits appearing in the following may be understood as information bits of the inner encoding. It should be further understood that a specific implementation of the outer encoding is not limited in this application. In an example, the outer encoding may be specifically staircase (512, 510) encoding.

102: Perform an exclusive OR operation on every s bits in the consecutive k bits of the first data stream to obtain a to-be-encoded sequence.

It should be understood that, in an inner codeword obtained through inner code encoding, consecutive s bits are mapped to one symbol through Gray mapping and sent to a channel for transmission. Therefore, under a non-extreme channel condition, only one bit error occurs in the consecutive s bits. A symbol mapping manner includes but is not limited to quadrature phase shift keying (Quadrature Phase Shift Keying, QPSK) and quadrature amplitude modulation (Quadrature Amplitude Modulation, QAM), and then polarization symbol distribution is performed to obtain a dual-polarization (Dual-polarization, DP) symbol, for example, DP-QPSK, DP-8QAM, DP-16QAM, DP-32QAM, and DP-64QAM. In an example, when DP-16QAM is used, consecutive two bits in the inner codeword are mapped to a same PAM4 symbol. In another example, when DP-64QAM is used, consecutive three bits in the inner codeword are mapped to a same PAM8 symbol. Therefore, in embodiments of this application, it is considered that an exclusive OR operation is first performed on every two or three bits in the consecutive k bits of the first data stream, and then encoding is performed. The following uses k=119 as an example to describe several possible exclusive OR operation manners.

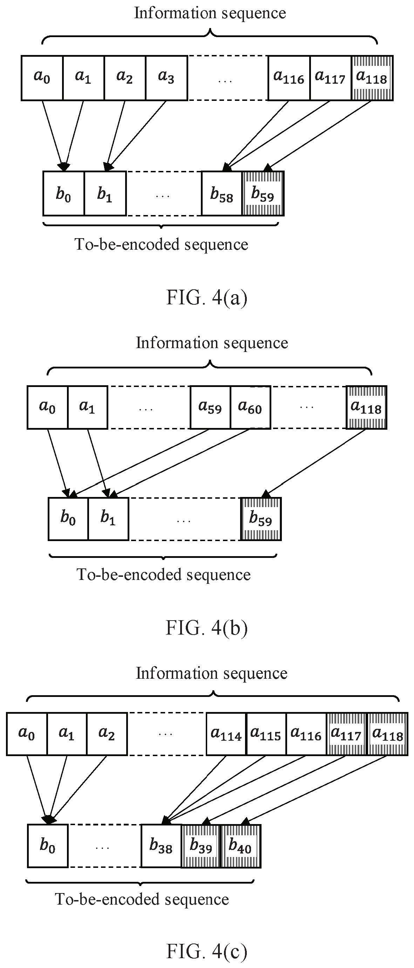

FIG. 4(a) is a diagram of an implementation of performing an exclusive OR operation on every two bits according to an embodiment of this application. As shown in FIG. 4(a), in a possible implementation, because 119 is an odd number, one bit in an information sequence including 119 bits cannot undergo a pairwise exclusive OR operation, and the bit is referred to as a target bit herein. It should be understood that the target bit may be any bit in the information sequence. Generally, the target bit is a $1^{st}$ bit or a last bit in the information sequence. For example, as shown in FIG. 4(a), the target bit is a last bit $a_{118}$ in the information sequence. For ease of description, the remaining 118 bits in the information sequence other than the target bit are referred to as a bit set herein. The bit set includes 59 bit subsets, and each bit subset includes two bits. Further, an exclusive OR operation is performed on the two bits in each bit subset to obtain one bit, so as to obtain a total of 59 bits, as shown in $b_0$ to $b_{58}$ in FIG. 4(a). In this implementation, the two bits in each bit subset are two adjacent bits in the 119-bit information sequence. As shown in FIG. 4(a), an exclusive OR operation is performed on $a_0$ and $a_1$ to obtain $b_0$, an exclusive OR operation is performed on $a_2$ and $a_3$ to obtain $b_1$, ..., and an exclusive OR operation is performed on $a_{116}$ and $a_{117}$ to obtain $b_{58}$. Further, the target bit $a_{118}$ in the information sequence is used as one bit $b_{59}$ in the to-be-encoded sequence, and the to-be-encoded sequence includes $b_0$ to $b_{58}$ that are obtained through exclusive OR operations and $b_{59}$.

FIG. 4(b) is a diagram of another implementation of performing an exclusive OR operation on every two bits according to an embodiment of this application. Different from the implementation shown in FIG. 4(a), in another possible implementation, the two bits in each bit subset may alternatively be any two non-adjacent bits in a 119-bit information sequence. A specific manner is not limited herein. For example, as shown in FIG. 4(b), an exclusive OR operation is performed on $a_0$ and $a_{59}$ to obtain $b_0$, an exclusive OR operation is performed on $a_1$ and $a_{60}$ to obtain $b_1$, ..., and an exclusive OR operation is performed on $a_{58}$ and $a_{117}$ to obtain $b_{58}$. Further, the target bit $a_{118}$ in the information sequence is used as one bit $b_{59}$ in the to-be-encoded sequence, and the to-be-encoded sequence includes $b_0$ to $b_{58}$ that are obtained through exclusive OR operations and $b_{59}$.

It should be noted that, based on the 2-bit exclusive OR operation implementations shown in FIG. 4(a) and FIG. 4(b), a specific value of k is not limited in this application. If k is an odd number greater than 1, one target bit in an information sequence including the k bits definitely does not participate in the exclusive OR operation. If k is an even number, an exclusive OR operation can be exactly performed on every two bits of all the k bits in the information sequence.

FIG. 4(c) is a diagram of an implementation of performing an exclusive OR operation on every three bits according to an embodiment of this application. As shown in FIG. 4(c), in still another possible implementation, because a remainder of 119 divided by 3 is 2, two bits in an information sequence including 119 bits cannot undergo a 3-bit exclusive OR operation, and the two bits are referred to as target bits herein. It should be understood that the two target bits may be any two bits in the information sequence. Generally, the two target bits are first two bits or last two bits in the information sequence. For example, as shown in FIG. 4(c), the two target bits are last two bits $a_{117}$ and $a_{118}$ in the information sequence. For ease of description, the remaining 117 bits in the information sequence other than the target bits are referred to as a bit set herein. The bit set includes 39 bit subsets, and each bit subset includes three bits. Further, an exclusive OR operation is performed on the three bits in each bit subset to obtain one bit, so as to obtain a total of 39 bits, as shown in $b_0$ to $b_{38}$ in FIG. 4(c). In this implementation, the three bits in each bit subset are consecutive three bits in the 119-bit information sequence. As shown in FIG. 4(c), an exclusive OR operation is performed on $a_0$, $a_1$, and $a_2$ to obtain $b_0$, ..., and an exclusive OR operation is performed on $a_{114}$, $a_{115}$, and $a_{116}$ to obtain $b_{38}$. Further, the target bits $a_{117}$ and $a_{118}$ in the information

sequence are used as two bits $b_{39}$ and $b_{40}$ in the to-be-encoded sequence, and the to-be-encoded sequence includes $b_0$ to $b_{38}$ that are obtained through exclusive OR operations, $b_{39}$, and $b_{40}$.

It should be noted that, based on the 3-bit exclusive OR operation implementation shown in FIG. 4(c), a specific value of k is not limited in this application. For example, k may alternatively be exactly an integer multiple of 3, and 3-bit exclusive OR operations may be exactly performed on all the k bits in the information sequence. For another example, a remainder of k divided by 3 may alternatively be 1, and in this case, one bit in the k bits of the information sequence is a target bit that does not participate in the exclusive OR operation, and 3-bit exclusive OR operations may be performed on other bits than the target bit.

103: Perform second FEC encoding on the to-be-encoded sequence.

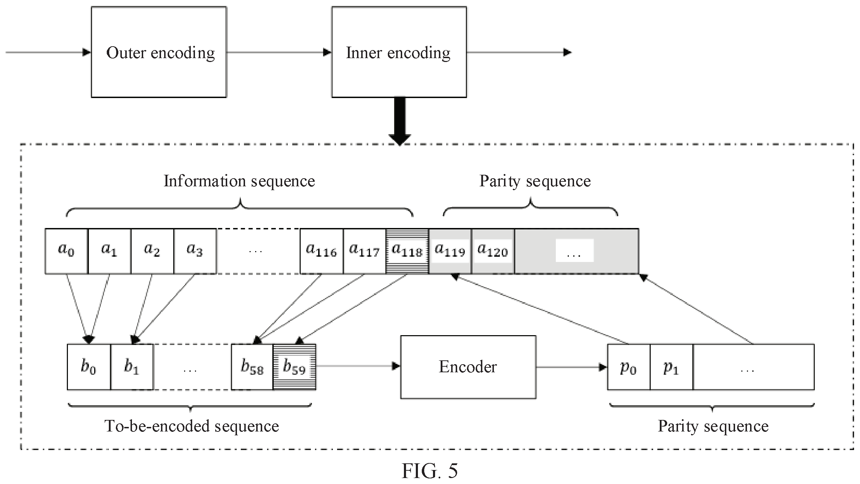

FIG. 5 is a diagram of an implementation of inner encoding according to an embodiment of this application. As shown in FIG. 5, the to-be-encoded sequence is a bit sequence on which the second FEC encoding is to be performed. The to-be-encoded sequence includes the bit obtained through the exclusive OR operation in step 102. Based on this, the to-be-encoded sequence may further include the target bit that does not participate in the exclusive OR operation. A specific case depends on a value of k. For details, refer to related descriptions in step 102. k=119 is used as an example herein. The second FEC encoding is performed on the to-be-encoded sequence to obtain a parity sequence including p parity bits. For the inner codeword obtained through inner encoding, the inner codeword includes the information sequence of the k bits and the p parity bits, that is, a length n of the inner codeword is n=k+p, where p is an integer greater than or equal to 1. That is, the second FEC encoding performed on the to-be-encoded sequence is only for generating the parity sequence, and the inner codeword obtained through encoding still includes the information sequence including the k bits. For example, if the target bit is a last bit in the to-be-encoded sequence, the parity sequence in the inner codeword is located after the information sequence. For another example, if the target bit is a 1$^{st}$ bit in the to-be-encoded sequence, the parity sequence in the inner codeword is located before the information sequence. It should be noted that the second FEC encoding may be BCH encoding or extended BCH encoding. p parity bits in an inner codeword obtained through the BCH encoding do not include a cyclic redundancy check (cyclic redundancy check, CRC) extended parity bit, while p parity bits in an inner codeword obtained through the extended BCH encoding include a 1-bit or 2-bit CRC extended check field.

In a possible implementation, for a 2-bit exclusive OR operation encoding scheme and a 3-bit exclusive OR operation encoding scheme, the second FEC encoding may be specifically BCH encoding over $GF(2^m)$ with t-bit error correction, where both m and t are integers greater than or equal to 1. GF refers to a finite field, or may be referred to as a Galois field (Galois Field), and $2^m$ represents an order of the finite field. An error correction capability of the second FEC encoding is t bits, that is, one inner codeword can be used to correct a maximum of t bits. If the P parity bits do not include a CRC extended check field, $p=m \times t$; if the P parity bits include the 1-bit CRC extended check field, $p=m \times t+1$; or if the P parity bits include the 2-bit CRC extended check field, $p=m \times t+2$.

In another possible implementation, for a 2-bit exclusive OR operation encoding scheme, if $\frac{k+1}{2} \le 2^{m-1} - 1 - p$, the second FEC encoding may alternatively use a BCH codeword over $GF(2^{m-1})$ to further simplify an inner encoding scheme. If the P parity bits do not include a CRC extended check field, $p=(m-1) \times t$; if the P parity bits include the 1-bit CRC extended check field, $p=(m-1) \times t+1$; or if the P parity bits include the 2-bit CRC extended check field, $p=(m-1) \times t+2$. It should be understood that, when the second FEC encoding is the BCH encoding over $GF(2^m)$, a length of the inner codeword is denoted as n0, or when the second FEC encoding uses the BCH codeword over $GF(2^{m-1})$, a length of the inner codeword is denoted as n1, where n0=k+(m-1)t=n1-t. In this case, an original (n0, k) codeword is replaced with a (n1, k) codeword. That is, a quantity of parity bits may be reduced by t when encoding is performed in this manner, so that a bit rate of the codeword is increased and overheads of the codeword are reduced when a length of information is unchanged.

In still another possible implementation, for a 3-bit exclusive OR operation encoding scheme, the k bits include v bit subsets, each bit subset includes three bits, v is an integer greater than or equal to 1, and a quantity of CRC extended check fields included in the p parity bits is denoted as r. If $v + r \le 2^{m-1} - 1 - p$, the second FEC encoding may alternatively use a BCH codeword over $GF(2^{m-1})$ to further simplify an inner encoding scheme. If the P parity bits do not include the CRC extended check field, $p=(m-1) \times t$; if the P parity bits include the 1-bit CRC extended check field, $p=(m-1)*t+1$; or if the P parity bits include the 2-bit CRC extended check field, $p=(m-1) \times t+2$. If $v + r \le 2^{m-2} - 1 - p$, the second FEC encoding may alternatively use a BCH codeword over $GF(2^{m-2})$ to further simplify an inner encoding scheme. If the P parity bits do not include the CRC extended check field, $p=(m-2) \times t$; if the P parity bits include the 1-bit CRC extended check field, $p=(m-2) \times t+1$; or if the P parity bits include the 2-bit CRC extended check field, $p=(m-2)*t+2$.

104: Perform symbol mapping and polarization distribution on a second data stream.

It should be understood that the second data stream includes at least one inner codeword obtained through inner encoding. In an example, for the 2-bit exclusive OR operation encoding scheme, symbol mapping and polarization distribution are performed on every eight bits in the second data stream to obtain one DP-16QAM symbol. The eight bits participating in symbol mapping and polarization distribution are from four bit subsets that participate in exclusive OR operations and that are in the information sequence. In another example, for the 3-bit exclusive OR operation encoding scheme, symbol mapping and polarization distribution are performed on every 12 bits in the second data stream to obtain one DP-64QAM symbol. The 12 bits participating in symbol mapping and polarization distribution are from four bit subsets that participate in exclusive OR operations and that are in the information sequence. It should be understood that the four bit subsets are respectively mapped to an I (in-phase) component in an X-polarization direction, a Q (quadrature-phase) component in the X-polarization direction, an I (in-phase) component in a Y-polarization direction, and a Q (quadrature-phase) component in the Y-polarization direction that are of the DP-16QAM symbol or the DP-64QAM symbol. The X polarization direction and the Y polarization direction are orthogonal to each other. In other words, any component of the DP-16QAM symbol is obtained by mapping two bits of one bit subset participating in the exclusive OR operation, and any component of the DP-64QAM symbol is obtained by mapping three bits of one bit subset participating in the exclusive OR operation. It should be further understood that the four bit subsets mapped to the DP-16QAM symbol or the DP-64QAM symbol may come from a same codeword, or may come from different codewords. This is not specifically limited herein.

It should be noted that an example in which a length of the information sequence of the inner codeword is 119 bits is used. Based on this, embodiments of this application provide a plurality of possible inner encoding parameters. When a DP-16QAM scheme is used, details are shown in Table 1 below, or when a DP-64QAM scheme is used, details are shown in Table 2 below. n represents the length of the inner codeword, k represents the length of the information sequence of the inner codeword, w represents an encoding length (including the to-be-encoded sequence and the parity sequence), f represents a length of the to-be-encoded sequence, and $GF(2^m)$ represents a finite field. t indicates an error correction capability of the inner encoding. OH represents overheads of the inner codeword, and means a proportion of a length of the parity sequence in the inner codeword to the length of the information sequence, that is, OH=(n-k)/k. "No extension" in the remarks means that there is no CRC extended check field in the parity sequence, "single-bit extension" in the remarks means that there is a 1-bit CRC extended check field in the parity sequence, and "double-bit extension" in the remarks means that there is a 2-bit CRC extended check field in the parity sequence.

Table 1

| Scheme | n | k | p | w | f | $GF(2^m)$ | t | OH | Remarks |
|---|---|---|---|---|---|---|---|---|---|
| 1 | 128 | 119 | 9 | 69 | 60 | $GF(2^7)$ | 1 | 7.6% | Double-bit extension |
| 2 | 133 | 119 | 14 | 74 | 60 | $GF(2^7)$ | 2 | 11.8% | No extension |
| 3 | 134 | 119 | 15 | 75 | 60 | $GF(2^7)$ | 2 | 12.6% | Single-bit extension |
| 4 | 135 | 119 | 16 | 76 | 60 | $GF(2^7)$ | 2 | 13.4% | Double-bit extension |
| 5 | 135 | 119 | 16 | 76 | 60 | $GF(2^8)$ | 2 | 13.4% | No extension |
| 6 | 136 | 119 | 17 | 77 | 60 | $GF(2^8)$ | 2 | 14.2% | Single-bit extension |
| 7 | 137 | 119 | 18 | 78 | 60 | $GF(2^8)$ | 2 | 15.1% | Double-bit extension |

For the schemes provided in Table 1, the scheme 1 is a codeword defined over a finite field $GF(2^7)$ with an error correction capability t=1, and encoding and decoding complexity can be reduced in a conventional technology by using an exclusive OR manner. In schemes 5 to 7, a codeword actually encoded is based on systematic BCH (255, 239) codeword over a finite field $GF(2^8)$ with t=2, and after the codeword is shortened by 179 bits, a BCH (76, 60) codeword actually encoded in the scheme 5 is obtained, which has a stronger coding gain in comparison with that in scheme 1. Based on the scheme 5, a single-bit CRC extended check field and a double-bit CRC extended check field are separately added, to obtain a BCH (77, 60) codeword actually encoded in the scheme 6 and a BCH (78, 60) codeword actually encoded in the scheme 7, and a coding gain may be further improved based on the scheme 5. In schemes 2 to 4, a codeword actually encoded is based on system BCH (127, 113) over a finite field $GF(2^7)$ with t=2, and after the codeword is shortened by 53 bits, a BCH (74, 60) codeword actually encoded in the scheme 2 is obtained. Based on the scheme 2, a single-bit CRC extended check field and a double-bit CRC extended check field are separately added, to obtain a BCH (75, 60) codeword actually encoded in the scheme 3 and a BCH (76, 60) codeword actually encoded in the scheme 4. Compared with the schemes 5 to 7, the schemes 2 to 4 satisfy the foregoing mentioned relationship: $\frac{k+1}{2} \leq 2^{m-1} - 1 - p$, and therefore, the original finite field $GF(2^8)$ may be replaced with the low-complexity finite field $GF(2^7)$.

Table 2

| Scheme | n | k | p | w | f | $GF(2^m)$ | t | OH | Remarks |
|---|---|---|---|---|---|---|---|---|---|
| 1 | 127 | 119 | 8 | 49 | 41 | $GF(2^6)$ | 1 | 6.7% | Double-bit extension |

(continued)

| Scheme | n | k | p | w | f | GF($2^m$) | t | OH | Remarks |
|---|---|---|---|---|---|---|---|---|---|
| 2 | 128 | 119 | 9 | 50 | 41 | GF($2^7$) | 1 | 7.6% | Double-bit extension |
| 3 | 131 | 119 | 12 | 53 | 41 | GF($2^6$) | 2 | 10.1% | No extension |
| 4 | 132 | 119 | 13 | 54 | 41 | GF($2^6$) | 2 | 10.9% | Single-bit extension |
| 5 | 133 | 119 | 14 | 55 | 41 | GF($2^6$) | 2 | 11.8% | Double-bit extension |
| 6 | 133 | 119 | 14 | 55 | 41 | GF($2^7$) | 2 | 11.8% | No extension |
| 7 | 134 | 119 | 15 | 56 | 41 | GF($2^7$) | 2 | 12.6% | Single-bit extension |
| 8 | 135 | 119 | 16 | 57 | 41 | GF($2^7$) | 2 | 13.4% | Double-bit extension |
| 9 | 135 | 119 | 16 | 57 | 41 | GF($2^8$) | 2 | 13.4% | No extension |
| 10 | 136 | 119 | 17 | 58 | 41 | GF($2^8$) | 2 | 14.2% | Single-bit extension |
| 11 | 137 | 119 | 18 | 59 | 41 | GF($2^8$) | 2 | 15.1% | Double-bit extension |

For the schemes provided in Table 2, scheme 1 and scheme 2 use a Hamming code defined over a finite field GF($2^6$) with an error correction capability t=1 and a Hamming code defined over a finite field GF($2^7$), respectively, each with an error correction capability t=1, schemes 3 to 5 use BCH codes over a finite field GF($2^6$) with an error correction capability t=2, schemes 6 to 8 use BCH codes over a finite field GF($2^7$) with an error correction capability t=2, and candidate schemes 9 to 11 use BCH codes over a finite field GF($2^8$) with an error correction capability t=2.

It should be noted that, in some possible scenarios, an inner encoding scheme in a DP-16QAM modulation scheme may be compatible with an inner encoding scheme in a DP-64QAM modulation scheme. Table 3 below provides parameters compatible with inner encoding of both modulation schemes. In actual application, encoders corresponding to the two modulation schemes may be integrated together, for flexible selection based on an actual requirement.

Table 3

| Scheme | n | k | p | w (16QAM) | f (16QAM) | w (64QAM) | f (64QAM) | GF($2^m$) | Remarks |
|---|---|---|---|---|---|---|---|---|---|
| 1 | 128 | 119 | 9 | 69 | 60 | 50 | 41 | GF($2^7$) | Double-bit extension |
| 2 | 133 | 119 | 14 | 74 | 60 | 55 | 41 | GF($2^7$) | No extension |
| 3 | 134 | 119 | 15 | 75 | 60 | 56 | 41 | GF($2^7$) | Single-bit extension |
| 4 | 135 | 119 | 16 | 76 | 60 | 57 | 41 | GF($2^7$) | Double-bit extension |
| 5 | 135 | 119 | 16 | 76 | 60 | 57 | 41 | GF($2^8$) | No extension |
| 6 | 136 | 119 | 17 | 77 | 60 | 58 | 41 | GF($2^8$) | Single-bit extension |
| 7 | 137 | 119 | 18 | 78 | 60 | 59 | 41 | GF($2^8$) | Double-bit extension |

The following describes several specific inner encoding embodiments based on parameters of the inner encoding.

Embodiment 1: In a DP-16QAM modulation scheme, inner encoding is (128, 119) with (69, 60) over GF($2^7$) encoding.

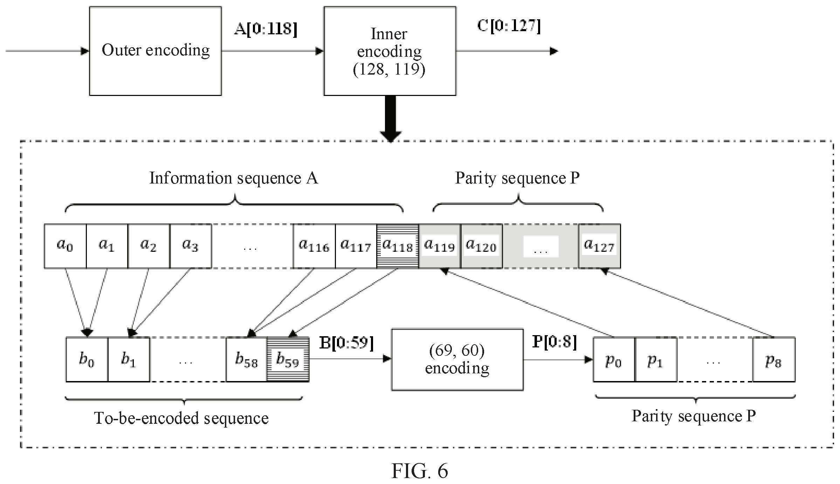

FIG. 6 is a diagram of a first application scenario of inner encoding according to an embodiment of this application. As shown in FIG. 6, a length of an inner encoded codeword is 128 bits, where a length of an information sequence is 119 bits, and a length of a parity sequence is 9 bits. First, 118 bits are selected from the 119-bit information sequence A to form a sequence A', and are denoted as $A' = [a'_0, a'_1, \cdots, a'_{117}]$. A' may be any 118 bits in A. To facilitate subsequent channel interleaving and modulation, first 118 bits in A may be selected as A', that is, A' = [$a_0, a_1, \cdots, a_{117}$]. Then, two adjacent bits in A' are grouped into one group to perform an exclusive OR operation, so as to obtain 59 bits [$b_0, b_1, \cdots, b_{58}$]. In addition, a bit in A that is not selected into A' is denoted as A\A', a grouping and exclusive OR operation is skipped for A\A', and A\A' is combined with $b_0 \sim b_{58}$ to form a to-be-encoded sequence B[0:59]=[$b_0, b_1, \cdots, b_{59}$], which is expressed as follows:

$$\begin{cases} b_i = a'_{2i} \wedge a'_{2i+1}, i \in [0, 58] \\ b_i = A \backslash A', \qquad i = 59 \end{cases}$$

Then, extended Hamming code (69, 60) encoding is performed on the to-be-encoded sequence to generate a 9-bit parity bit [$p_0, p_1, \cdots, p_8$]. An extended Hamming code (69, 60) is obtained by shortening, by 59 bits, a double-bit extended Hamming code constructed over a finite field $GF(2^7)$. Finally, a codeword C $[0:127] = [c_0, c_1, \cdots, c_{127}]$ generated by inner encoding (128, 119) may be represented as
$$\begin{cases} c_i = a_i, & i \in [0,118] \\ c_i = p_{i-119}, & i \in [119,127] \end{cases}$$
. It should be understood that, in the foregoing process, SD-FEC (128, 119) is still a system code, that is, (69, 60) encoding is only used for generating a parity bit, and does not participate in actual transmission.

Embodiment 2: In a DP-16QAM modulation scheme, inner encoding is (133, 119) with (74, 60) over $GF(2^7)$ encoding.

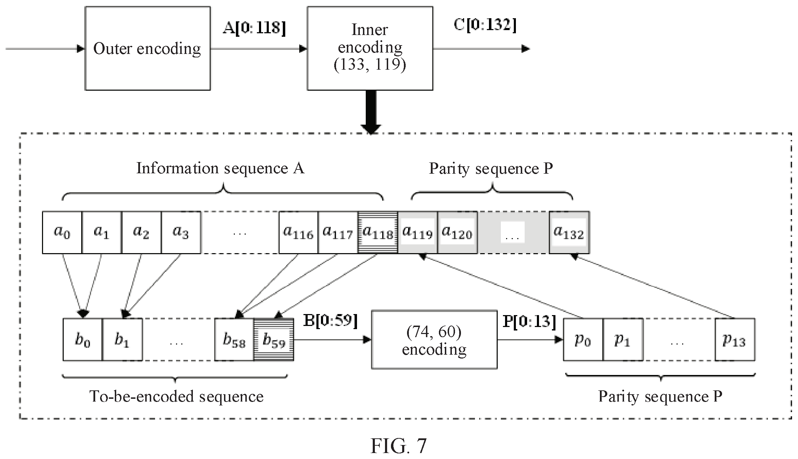

FIG. 7 is a diagram of a second application scenario of inner encoding according to an embodiment of this application. As shown in FIG. 7, a length of an inner encoded codeword is 133 bits, where a length of an information sequence is 119 bits, and a length of a parity sequence is 14 bits. First, a to-be-encoded sequence B[0:59] is generated based on an information sequence A[0:118] in a manner the same as that in Embodiment 1. Then, BCH (74, 60) encoding is performed on the to-be-encoded sequence to generate a 14-bit parity bit $[p_0, p_1, \cdots, p_{13}]$. BCH (74, 60) is obtained by shortening, by 53 bits, BCH (127, 113) constructed over a finite field $GF(2^7)$ with t=2. A generator polynomial of the BCH (74, 60) over $GF(2^7)$ may be expressed as:

$$g(x) = M1(x)M3(x) = (x^7 + x^3 + 1)(x^7 + x^3 + x^2 + x + 1)$$
$$= x^{14} + x^9 + x^8 + x^6 + x^5 + x^4 + x^2 + x + 1$$

M1(x) and M3(x) respectively correspond to minimum polynomials of $\alpha^1$ and $\alpha^3$, and $\alpha$ is a primitive element of the finite field $GF(2^7)$. 60 bits to be encoded are respectively used as coefficients of a polynomial with a highest degree of 59, to obtain an information polynomial m(x). A remainder polynomial r(x) is obtained, using modulo-2 division, by dividing $x^{14}m(x)$ by g(x), and coefficients of items in r(x) are a parity sequence P[0:13]. Finally, the information sequence A and the parity sequence P form a complete codeword of inner encoding (133, 119), which is denoted as C[0:132]= $[c_0, c_1, \cdots, c_{132}]$ and may be represented as $\begin{cases} c_i = a_i, & i \in [0,118] \\ c_i = p_{i-119}, & i \in [119,132] \end{cases}$.

Embodiment 3: In a DP-16QAM modulation scheme, inner encoding is (134, 119) with (75, 60) over $GF(2^7)$ encoding.

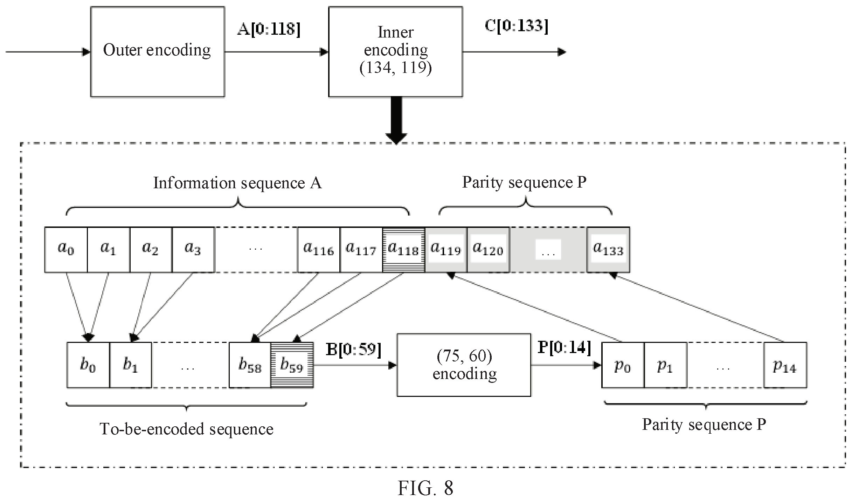

FIG. 8 is a diagram of a third application scenario of inner encoding according to an embodiment of this application. As shown in FIG. 8, a length of an inner encoded codeword is 134 bits, where a length of an information sequence is 119 bits, and a length of a parity sequence is 15 bits. First, a to-be-encoded sequence B[0:59] is generated based on an information sequence A[0:118] in a manner the same as that in Embodiment 1. Then, extended BCH (75, 60) encoding is performed on the to-be-encoded sequence to generate a 15-bit parity bit $[p_0, p_1, \cdots, p_{14}]$. Extended BCH (75, 60) is obtained by adding single-bit parity check based on the BCH (74, 60) in Embodiment 2. A generator polynomial of the extended BCH (75, 60) over $GF(2^7)$ may be expressed as:

$$g1(x) = g(x)(x + 1) = (x^7 + x^3 + 1)(x^7 + x^3 + x^2 + x + 1)(x + 1)$$
$$= x^{15} + x^{14} + x^{10} + x^8 + x^7 + x^4 + x^3 + 1$$

60 bits to be encoded are respectively used as coefficients of a polynomial with a highest degree of 59, to obtain an information polynomial m(x). A remainder polynomial r(x) is obtained, using modulo-2 division, by dividing $x^{15}m(x)$ by g1(x), and coefficients of items in r(x) are a parity sequence P[0:14]. Finally, the information sequence A and the parity sequence P form a complete codeword of inner encoding (134, 119), which is denoted as C[0:133]= $[c_0, c_1, \cdots, c_{133}]$ and may be represented as $\begin{cases} c_i = a_i, & i \in [0,118] \\ c_i = p_{i-119}, & i \in [119,133] \end{cases}$.

Embodiment 4: In a DP-16QAM modulation scheme, inner encoding is (135, 119) with (76, 60) over $GF(2^7)$ encoding.

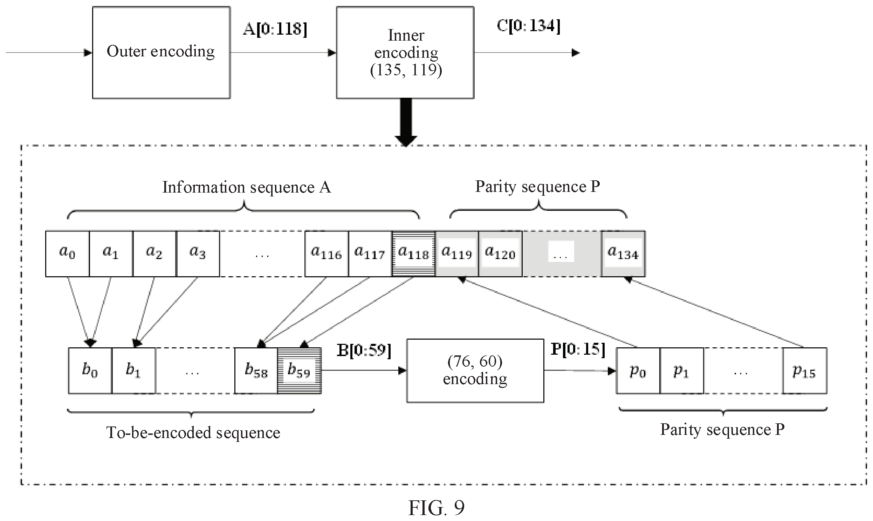

FIG. 9 is a diagram of a fourth application scenario of inner encoding according to an embodiment of this application. As shown in FIG. 9, a length of an inner encoded codeword is 135 bits, where a length of an information sequence is 119 bits, and a length of a parity sequence is 16 bits. First, a to-be-encoded sequence B[0:59] is generated based on an information sequence A[0:118] in a manner the same as that in Embodiment 1. Then, extended BCH (76, 60) encoding is performed on the to-be-encoded sequence to generate a 16-bit parity bit $[p_0, p_1, \cdots, p_{15}]$. Extended BCH (76, 60) is obtained by adding double-bit parity check based on the BCH (74, 60) in Embodiment 2. A generator polynomial of

The extended BCH (76, 60) over $GF(2^7)$ may be expressed as:

$$g2(x) = g(x)(x^2 + 1) = (x^7 + x^3 + 1)(x^7 + x^3 + x^2 + x + 1)(x^2 + 1)$$

$$= x^{16} + x^{14} + x^{11} + x^{10} + x^9 + x^7 + x^5 + x^3 + x + 1$$

60 bits to be encoded are respectively used as coefficients of a polynomial with a highest degree of 59, to obtain an information polynomial m(x). A remainder polynomial r(x) is obtained, using modulo-2 division, by dividing $x^{16}$m(x) by g2(x), and coefficients of items in r(x) are a parity sequence P[0:15]. Finally, the information sequence A and the parity sequence P form a complete codeword of inner encoding (135, 119), which is denoted as C[0:134]= $[c_0, c_1, \cdots, c_{134}]$ and

may be represented as $\begin{cases} c_i = a_i, & i \in [0,118] \\ c_i = p_{i-119}, & i \in [119,134] \end{cases}$.

Embodiment 5: In a DP-16QAM modulation scheme, inner encoding is (135, 119) with (76, 60) over $GF(2^8)$ encoding.

As shown in FIG. 9, a length of an inner encoded codeword is 135 bits, where a length of an information sequence is 119 bits, and a length of a parity sequence is 16 bits. First, a to-be-encoded sequence B[0:59] is generated based on an information sequence A[0:118] in a manner the same as that in Embodiment 1. Then, BCH (76, 60) encoding is performed on the to-be-encoded sequence to generate a 16-bit parity bit $[p_0, p_1, \cdots, p_{15}]$. BCH (76, 60) is obtained by shortening, by 179 bits, BCH (255, 239) constructed over a finite field $GF(2^8)$ with t=2. A generator polynomial of the BCH (76, 60) over $GF(2^8)$ may be expressed as:

$$g3(x) = M1(x)M3(x) = (x^8 + x^4 + x^3 + x^2 + 1)(x^8 + x^6 + x^5 + x^4 + x^2 + x + 1)$$

$$= x^{16} + x^{14} + x^{13} + x^{11} + x^{10} + x^9 + x^8 + x^6 + x^5 + x + 1$$

60 bits to be encoded are respectively used as coefficients of a polynomial with a highest degree of 59, to obtain an information polynomial m(x). A remainder polynomial r(x) is obtained, using modulo-2 division, by dividing $x^{16}$m(x) by g3(x), and coefficients of items in r(x) are a parity sequence P[0:15]. Finally, the information sequence A and the parity sequence P form a complete codeword of inner encoding (135, 119), which is denoted as C[0:134]= $[c_0, c_1, \cdots, c_{134}]$ and

may be represented as $\begin{cases} c_i = a_i, & i \in [0,118] \\ c_i = p_{i-119}, & i \in [119,134] \end{cases}$.

Embodiment 6: In a DP-16QAM modulation scheme, inner encoding is (136, 119) with (77, 60) over $GF(2^8)$ encoding.

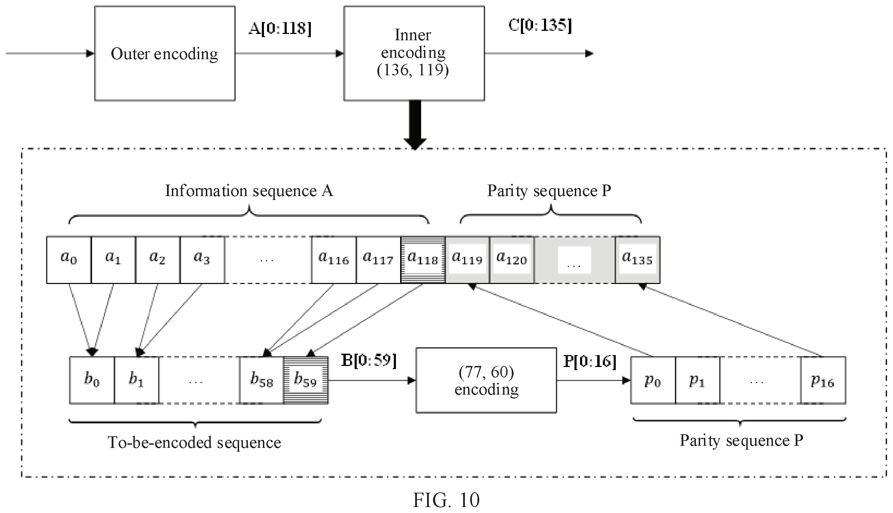

FIG. 10 is a diagram of a fifth application scenario of inner encoding according to an embodiment of this application. As shown in FIG. 10, a length of an inner encoded codeword is 136 bits, where a length of an information sequence is 119 bits, and a length of a parity sequence is 17 bits. First, a to-be-encoded sequence B[0:59] is generated based on an information sequence A[0:118] in a manner the same as that in Embodiment 1. Then, extended BCH (77, 60) encoding is performed on the to-be-encoded sequence to generate a 17-bit parity bit $[p_0, p_1, \cdots, p_{16}]$. Extended BCH (77, 60) is obtained by adding single-bit parity check based on the BCH (76, 60) in Embodiment 5. A generator polynomial of the extended BCH (77, 60) over $GF(2^8)$ may be expressed as:

$$g4(x) = g3(x)(x + 1)$$

$$= (x^8 + x^4 + x^3 + x^2 + 1)(x^8 + x^6 + x^5 + x^4 + x^2 + x + 1)(x + 1)$$

$$= x^{17} + x^{16} + x^{15} + x^{13} + x^{12} + x^8 + x^7 + x^5 + x^2 + 1$$

60 bits to be encoded are respectively used as coefficients of a polynomial with a highest degree of 59, to obtain an information polynomial m(x). A remainder polynomial r(x) is obtained, using modulo-2 division, by dividing $x^{17}$m(x) by g4(x), and coefficients of items in r(x) are a parity sequence P[0:16]. Finally, the information sequence A and the parity sequence P form a complete codeword of inner encoding (136, 119), which is denoted as C[0:135]= $[c_0, c_1, \cdots, c_{135}]$ and

may be represented as $\begin{cases} c_i = a_i, & i \in [0,118] \\ c_i = p_{i-119}, & i \in [119,135] \end{cases}$.

Embodiment 7: In a DP-16QAM modulation scheme, inner encoding is (137, 119) with (78, 60) over $GF(2^8)$ encoding.

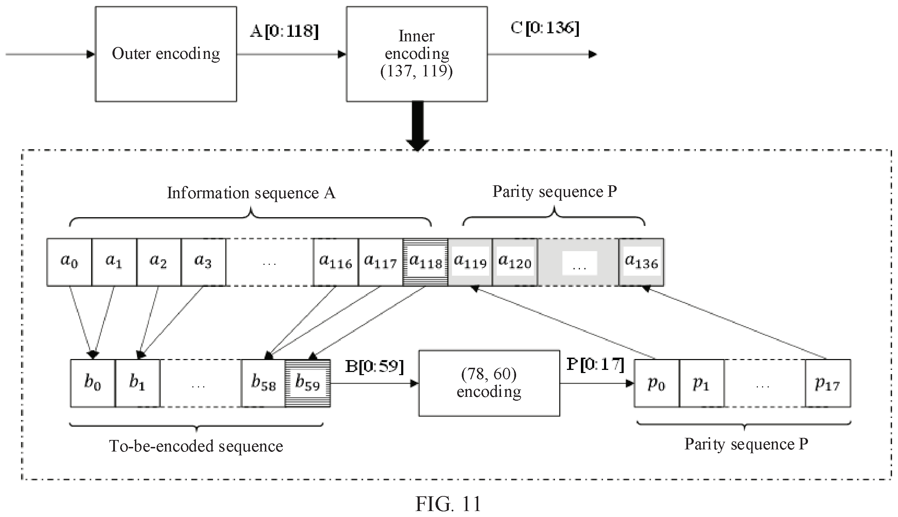

FIG. 11 is a diagram of a sixth application scenario of inner encoding according to an embodiment of this application. As shown in FIG. 11, a length of an inner encoded codeword is 137 bits, where a length of an information sequence is 119 bits, and a length of a parity sequence is 18 bits. First, a to-be-encoded sequence B[0:59] is generated based on an information sequence A[0:118] in a manner the same as that in Embodiment 1. Then, extended BCH (78, 60) encoding is performed on the to-be-encoded sequence to generate an 18-bit parity bit $[p_0, p_1, \cdots, p_{17}]$. Extended BCH (78, 60) is obtained by adding double-bit parity check based on the BCH (76, 60) in Embodiment 5. A generator polynomial of the extended BCH (78, 60) over $GF(2^8)$ may be expressed as:

$$g5(x) = g3(x)(x^2 + 1)$$
$$= (x^8 + x^4 + x^3 + x^2 + 1)(x^8 + x^6 + x^5 + x^4 + x^2 + x + 1)(x^2 + 1)$$
$$= x^{18} + x^{15} + x^{14} + x^{12} + x^9 + x^7 + x^6 + x^5 + x^3 + x^2 + x + 1$$

60 bits to be encoded are respectively used as coefficients of a polynomial with a highest degree of 59, to obtain an information polynomial m(x). A remainder polynomial r(x) is obtained, using modulo-2 division, by dividing $x^{18}m(x)$ by g5(x), and coefficients of items in r(x) are a parity sequence P[0:17]. Finally, the information sequence A and the parity sequence P form a complete codeword of inner encoding (137, 119), which is denoted as C[0:136]= $[c_0, c_1, \cdots, c_{136}]$ and may be represented as $\begin{cases} c_i = a_i, & i \in [0,118] \\ c_i = p_{i-119}, & i \in [119,136] \end{cases}$.

Embodiment 8: In a DP-64QAM modulation scheme, inner encoding is (128, 119) with (50, 41) over $GF(2^7)$ encoding.

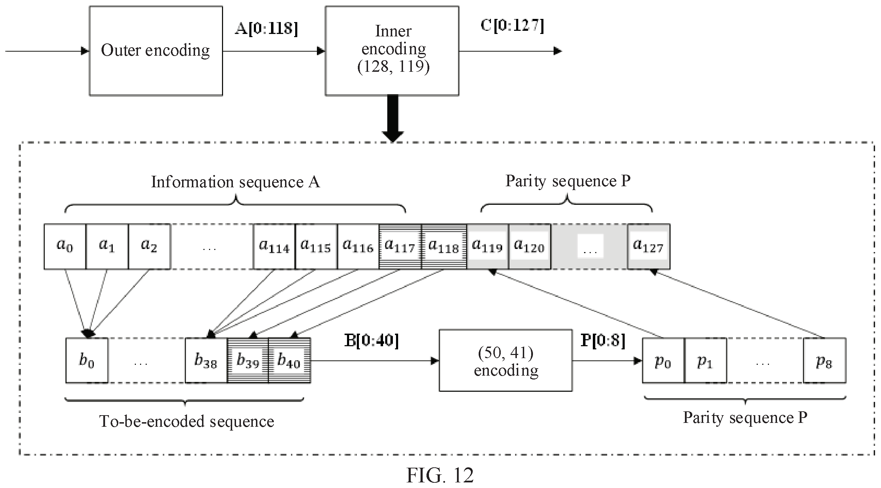

FIG. 12 is a diagram of a seventh application scenario of inner encoding according to an embodiment of this application. As shown in FIG. 12, a length of an inner encoded codeword is 128 bits, where a length of an information sequence is 119 bits, and a length of a parity sequence is 9 bits. First, 117 bits are selected from the 119-bit information sequence A to form a sequence A', and are denoted as $A' = [a'_0, a'_1, \cdots, a'_{116}]$. A' may be any 117 bits in A. To facilitate subsequent channel interleaving and modulation, first 117 bits in A may be selected as A', that is, A' = $[a_0, a_1, \cdots, a_{116}]$. Then, consecutive three bits in A' are grouped into one group to perform an exclusive OR operation, so as to obtain 39 bits $[b_0, b_1, \cdots, b_{38}]$. In addition, bits in A that are not selected into A' are denoted as A\A', a grouping and exclusive OR operation is skipped for A\A', and A\A' is combined with $b_0 \sim b_{38}$ to form a to-be-encoded sequence B[0:40]=$[b_0, b_1, \cdots, b_{40}]$, which is expressed as follows: $\begin{cases} b_i = a'_{3i} \wedge a'_{3i+1} \wedge a'_{3i+2}, & i \in [0,38] \\ b_i = A\backslash A', & i \in [39,40] \end{cases}$. Then, extended Hamming code (50, 41) encoding is performed on the to-be-encoded sequence to generate a 9-bit parity bit $[p_0, p_1, \cdots, p_8]$. Extended Hamming code (50, 41) is obtained by shortening, by 79 bits, a double-bit extended Hamming code constructed over a finite field $GF(2^7)$. Finally, a codeword C[0:127] = $[c_0, c_1, \cdots, c_{127}]$ generated by inner encoding (128, 119) may be represented as $\begin{cases} c_i = a_i, & i \in [0,118] \\ c_i = p_{i-119}, & i \in [119,127] \end{cases}$.

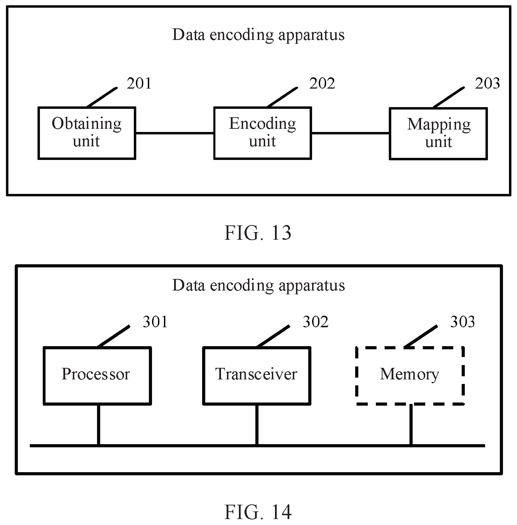

FIG. 13 is a diagram of a structure of a data encoding apparatus according to an embodiment of this application. As shown in FIG. 13, the data encoding apparatus includes an obtaining unit 201, an encoding unit 202, and a mapping unit 203. The obtaining unit 201 is configured to perform an operation in step 101, the encoding unit 202 is configured to perform operations in step 102 and step 103, and the mapping unit 203 is configured to perform an operation in step 104. It should be understood that the data encoding apparatus provided in this application may alternatively be implemented in another manner. For example, division into the units in the foregoing apparatus is merely logical function division and may be other division in actual implementation. For example, a plurality of units or components may be combined or integrated into another system. In addition, functional units in embodiments of this application may be integrated into one processing unit, may be independent physical units, or two or more functional units may be integrated into one processing unit. The integrated unit may be implemented in a form of hardware, or may be implemented in a form of a software functional unit.

FIG. 14 is a diagram of another structure of a data encoding apparatus according to an embodiment of this application. As shown in FIG. 14, the data encoding apparatus includes a processor 301 and a transceiver 302. The processor 301 and the transceiver 302 are interconnected through a line. Specifically, the transceiver 302 is configured to perform data receiving and sending operations, and the processor 301 is configured to perform other operations than data receiving and sending operations. In a possible implementation, the processor 301 may include the encoding unit 202 and the mapping unit 203 shown in FIG. 13, and the transceiver 302 includes the obtaining unit 201 shown in FIG. 13. Optionally, the data encoding apparatus may further include a memory 303. The memory 303 is configured to store program instructions and data.

An embodiment of this application further provides a chip. The chip integrates a circuit and one or more interfaces that are configured to implement a function of the processor 301. When a memory is integrated into the chip, the chip may complete the method steps in any one or more of the foregoing embodiments. When no memory is integrated into the chip, the chip may be connected to an external memory through an interface. The chip implements, based on program code stored in the external memory, actions performed by the transmitter device or the receiver device in the foregoing embodiments.

Finally, it should be noted that, the foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data encoding method, comprising:

    obtaining consecutive k bits in a first data stream obtained through first forward error correction FEC encoding, wherein k is an odd number greater than 1, the consecutive k bits comprise a bit set and a target bit, the bit set comprises (k-1)/2 bit subsets, and each bit subset comprises two bits; and
    performing inner encoding on the consecutive k bits to obtain a codeword, wherein the inner encoding comprises:

        performing an exclusive OR operation on the two bits in each bit subset to obtain one bit, to obtain a total of (k-1)/2 bits; and
        performing second FEC encoding on a bit sequence that comprises the (k-1)/2 bits and the target bit to obtain p parity bits, wherein the codeword comprises the consecutive k bits and the p parity bits, and p is an integer greater than or equal to 1.

2. The method according to claim 1, wherein the two bits in each bit subset are two adjacent bits in the consecutive k bits.

3. The method according to claim 1 or 2, wherein the p parity bits are located after the consecutive k bits in the codeword, and the target bit is a last bit in the consecutive k bits; or
the p parity bits are located before the consecutive k bits in the codeword, and the target bit is a $1^{st}$ bit in the consecutive k bits.

4. The method according to any one of claims 1 to 3, wherein after performing the inner encoding on the consecutive k bits to obtain the codeword, the method further comprises:
performing symbol mapping and polarization distribution on eight bits from four bit subsets in a second data stream that comprises at least one codeword to obtain one dual-polarization DP-16QAM symbol, wherein the four bit subsets are respectively mapped to an I component in an X polarization direction, a Q component in the X polarization direction, an I component in a Y polarization direction, and a Q component in the Y polarization direction that are of the DP-16QAM symbol, and the X polarization direction and the Y polarization direction are orthogonal to each other.

5. The method according to any one of claims 1 to 4, wherein the second FEC encoding is BCH encoding or extended BCH encoding over a finite field $GF(2^m)$ with t-bit error correction, wherein both m and t are integers greater than or equal to 1, mt ≤ p, and $\frac{k+1}{2} + p \leq 2^m - 1$.

6. The method according to any one of claims 1 to 5, wherein k=119, and $GF(2^m)$ used in the second FEC encoding is $GF(2^8)$ or $GF(2^7)$.

7. The method according to any one of claims 1 to 6, wherein a length of the codeword is n, the second FEC encoding is the BCH encoding over $GF(2^m)$ with t-bit error correction, and a correspondence among n, k, $GF(2^m)$, t, and p is one of the following:

    n=133, k=119, $GF(2^m)=GF(2^7)$, t=2, and p=14; and
    n=135, k=119, $GF(2^m)=GF(2^8)$, t=2, and p=16.

8. The method according to any one of claims 1 to 6, wherein a length of the codeword is n, the second FEC encoding is the extended BCH encoding over the finite field GF($2^m$) with t-bit error correction, the p parity bits comprise a cyclic redundancy check CRC extended check field of q bits, and a correspondence among n, k, GF($2^m$), t, p, and q is one of the following:

n=128, k=119, GF($2^m$)=GF($2^7$), t=1, p=9, and q=2;
n=134, k=119, GF($2^m$)=GF($2^7$), t=2, p=15, and q=1;
n=135, k=119, GF($2^m$)=GF($2^7$), t=2, p=16, and q=2;
n=136, k=119, GF($2^m$)=GF($2^8$), t=2, p=17, and q=1; and
n=137, k=119, GF($2^m$)=GF($2^8$), t=2, p=18, and q=2.

9. A data encoding method, comprising:

obtaining consecutive k bits in a first data stream obtained through first forward error correction FEC encoding, wherein k is an integer greater than or equal to 3, the consecutive k bits comprise v bit subsets, each bit subset comprises three bits, and v is an integer greater than or equal to 1; and
performing inner encoding on the consecutive k bits to obtain a codeword, wherein the inner encoding comprises:

performing an exclusive OR operation on the three bits in each bit subset to obtain one bit, to obtain a total of v bits; and
performing second FEC encoding on a bit sequence that comprises the v bits to obtain p parity bits, wherein the codeword comprises the consecutive k bits and the p parity bits, and p is an integer greater than or equal to 1.

10. The method according to claim 9, wherein the three bits in each bit subset are consecutive three bits in the consecutive k bits.

11. The method according to claim 9 or 10, wherein k=v$\times$3.

12. The method according to claim 9 or 10, wherein the consecutive k bits further comprise r target bits, k=v$\times$3+r, r=1 or 2, and performing the second FEC encoding on the bit sequence that comprises the v bits to obtain the p parity bits comprises:
performing the second FEC encoding on the bit sequence that comprises the v bits and the r target bits, to obtain the p parity bits.

13. The method according to claim 12, wherein the p parity bits are located after the consecutive k bits in the codeword, and the target bits are last r bits in the consecutive k bits; or
the p parity bits are located before the consecutive k bits in the codeword, and the target bits are first r bits in the consecutive k bits.

14. The method according to any one of claims 9 to 13, wherein after performing the inner encoding on the consecutive k bits to obtain the codeword, the method further comprises:
performing symbol mapping and polarization distribution on 12 bits from four bit subsets in a second data stream that comprises at least one codeword to obtain one dual-polarization DP-64QAM symbol, wherein the four bit subsets are respectively mapped to an I component in an X polarization direction, a Q component in the X polarization direction, an I component in a Y polarization direction, and a Q component in the Y polarization direction that are of the DP-64QAM symbol, and the X polarization direction and the Y polarization direction are orthogonal to each other.

15. The method according to any one of claims 9 to 14, wherein the second FEC encoding is BCH encoding or extended BCH encoding over a finite field GF($2^m$) with t-bit error correction, wherein both m and t are integers greater than or equal to 1, mt $\leq$ p, and v + r $\leq 2^m$ - 1 - $p$.

16. The method according to any one of claims 9 to 15, wherein k=119, and GF($2^m$) used in the second FEC encoding is GF($2^8$), GF($2^7$), or GF($2^6$).

17. The method according to any one of claims 9 to 16, wherein a length of the codeword is n, the second FEC encoding is the BCH encoding over GF($2^m$) with t-bit error correction, and a correspondence among n, k, GF($2^m$), t, and p is one of the following:

n=131, k=119, $GF(2^m)=GF(2^6)$, t=2, and p=12;
n=133, k=119, $GF(2^m)=GF(2^7)$, t=2, and p=14; and
n=135, k=119, $GF(2^m)=GF(2^8)$, t=2, and p=16.

18. The method according to any one of claims 9 to 16, wherein a length of the codeword is n, the second FEC encoding is the extended BCH encoding over the finite field $GF(2^m)$ with t-bit error correction, the p parity bits comprise a cyclic redundancy check CRC extended check field of q bits, and a correspondence among n, k, $GF(2^m)$, t, p, and q is one of the following:

n=127, k=119, $GF(2^m)=GF(2^6)$, t=1, p=8, and q=2;
n=128, k=119, $GF(2^m)=GF(2^7)$, t=1, p=9, and q=2;
n=132, k=119, $GF(2^m)=GF(2^6)$, t=2, p=13, and q=1;
n=133, k=119, $GF(2^m)=GF(2^6)$, t=2, p=14, and q=2;
n=134, k=119, $GF(2^m)=GF(2^7)$, t=2, p=15, and q=1;
n=135, k=119, $GF(2^m)=GF(2^7)$, t=2, p=16, and q=2;
n=136, k=119, $GF(2^m)=GF(2^8)$, t=2, p=17, and q=1; and
n=137, k=119, $GF(2^m)=GF(2^8)$, t=2, p=18, and q=2.

19. A data encoding apparatus, comprising an obtaining unit and an encoding unit, wherein

the obtaining unit is configured to: obtain consecutive k bits in a first data stream obtained through first forward error correction FEC encoding, wherein k is an odd number greater than 1, the consecutive k bits comprise a bit set and a target bit, the bit set comprises (k-1)/2 bit subsets, and each bit subset comprises two bits; and
the encoding unit is configured to: perform inner encoding on the consecutive k bits to obtain a codeword, wherein the encoding unit is specifically configured to: perform an exclusive OR operation on the two bits in each bit subset to obtain one bit, to obtain a total of (k-1)/2 bits; and
perform second FEC encoding on a bit sequence that comprises the (k-1)/2 bits and the target bit to obtain p parity bits, wherein the codeword comprises the consecutive k bits and the p parity bits, and p is an integer greater than or equal to 1.

20. The data encoding apparatus according to claim 19, wherein the two bits in each bit subset are two adjacent bits in the consecutive k bits.

21. The data encoding apparatus to claim 19 or 20, wherein the p parity bits are located after the consecutive k bits in the codeword, and the target bit is a last bit in the consecutive k bits; or
the p parity bits are located before the consecutive k bits in the codeword, and the target bit is a 1st bit in the consecutive k bits.

22. The data encoding apparatus according to any one of claims 19 to 21, wherein the data encoding apparatus further comprises a mapping unit, and the mapping unit is configured to:
perform symbol mapping and polarization distribution on eight bits from four bit subsets in a second data stream that comprises at least one codeword to obtain one dual-polarization DP-16QAM symbol, wherein the four bit subsets are respectively mapped to an I component in an X polarization direction, a Q component in the X polarization direction, an I component in a Y polarization direction, and a Q component in the Y polarization direction that are of the DP-16QAM symbol, and the X polarization direction and the Y polarization direction are orthogonal to each other.

23. The data encoding apparatus according to any one of claims 19 to 22, wherein the second FEC encoding is BCH encoding or extended BCH encoding over a finite field $GF(2^m)$ with t-bit error correction, wherein both m and t are integers greater than or equal to 1, $mt \leq p$, and $\frac{k+1}{2} + p \leq 2^m - 1$ .

24. The data encoding apparatus according to any one of claims 19 to 23, wherein k=119, and $GF(2^m)$ used in the second FEC encoding is $GF(2^8)$ or $GF(2^7)$.

25. The data encoding apparatus according to any one of claims 19 to 24, wherein a length of the codeword is n, the second FEC encoding is the BCH encoding over $GF(2^m)$ with t-bit error correction, and a correspondence among n, k, $GF(2^m)$, t, and p is one of the following:

n=133, k=119, GF($2^m$)= GF($2^7$), t=2, and p=14; and
n=135, k=119, GF($2^m$)= GF($2^8$), t=2, and p=16.

26. The data encoding apparatus according to any one of claims 19 to 24, wherein a length of the codeword is n, the second FEC encoding is the extended BCH encoding over the finite field GF($2^m$) with t-bit error correction, the p parity bits comprise a cyclic redundancy check CRC extended check field of q bits, and a correspondence among n, k, GF($2^m$), t, p, and q is one of the following:

n=128, k=119, GF($2^m$)=GF($2^7$), t=1, p=9, and q=2;
n=134, k=119, GF($2^m$)= GF($2^7$), t=2, p=15, and q=1;
n=135, k=119, GF($2^m$)= GF($2^7$), t=2, p=16, and q=2;
n=136, k=119, GF($2^m$)= GF($2^8$), t=2, p=17, and q=1; and
n=137, k=119, GF($2^m$)= GF($2^8$), t=2, p=18, and q=2.

27. A data encoding apparatus, comprising an obtaining unit and an encoding unit, wherein

the obtaining unit is configured to: obtain consecutive k bits in a first data stream obtained through first forward error correction FEC encoding, wherein k is an integer greater than or equal to 3, the consecutive k bits comprise v bit subsets, each bit subset comprises three bits, and v is an integer greater than or equal to 1; and
the encoding unit is configured to: perform inner encoding on the consecutive k bits to obtain a codeword, wherein the encoding unit is specifically configured to: perform an exclusive OR operation on the three bits in each bit subset to obtain one bit, to obtain a total of v bits; and
perform second FEC encoding on a bit sequence that comprises the v bits to obtain p parity bits, wherein the codeword comprises the consecutive k bits and the p parity bits, and p is an integer greater than or equal to 1.

28. The data encoding apparatus according to claim 27, wherein the three bits in each bit subset are consecutive three bits in the consecutive k bits.

29. The data encoding apparatus according to claim 27 or 28, wherein k=v×3.

30. The data encoding apparatus according to claim 27 or 28, wherein the consecutive k bits further comprise r target bits, k=v×3+r, r=1 or 2, and the encoding unit is specifically configured to:
perform the second FEC encoding on the bit sequence that comprises the v bits and the r target bits, to obtain the p parity bits.

31. The data encoding apparatus according to claim 30, wherein the p parity bits are located after the consecutive k bits in the codeword, and the target bits are last r bits in the consecutive k bits; or
the p parity bits are located before the consecutive k bits in the codeword, and the target bits are first r bits in the consecutive k bits.

32. The data encoding apparatus according to any one of claims 27 to 31, wherein the data encoding apparatus further comprises a mapping unit, and the mapping unit is configured to:
perform symbol mapping and polarization distribution on 12 bits from four bit subsets in a second data stream that comprises at least one codeword to obtain one dual-polarization DP-64QAM symbol, wherein the four bit subsets are respectively mapped to an I component in an X polarization direction, a Q component in the X polarization direction, an I component in a Y polarization direction, and a Q component in the Y polarization direction that are of the DP-64QAM symbol, and the X polarization direction and the Y polarization direction are orthogonal to each other.

33. The data encoding apparatus according to any one of claims 27 to 32, wherein the second FEC encoding is BCH encoding or extended BCH encoding over a finite field GF($2^m$) with t-bit error correction, wherein both m and t are integers greater than or equal to 1, mt ≤ p, and v + r ≤ $2^m$ - 1 - *p.*

34. The data encoding apparatus according to any one of claims 27 to 33, wherein k= 119, and GF($2^m$) used in the second FEC encoding is GF($2^8$), GF($2^7$), or GF($2^6$).

35. The data encoding apparatus according to any one of claims 27 to 34, wherein a length of the codeword is n, the second FEC encoding is the BCH encoding over GF($2^m$) with t-bit error correction, and a correspondence among n, k, GF($2^m$), t, and p is one of the following:

n=131, k=119, GF($2^m$)=GF($2^6$), t=2, and p=12;
n=133, k=119, GF($2^m$)=GF($2^7$), t=2, and p=14; and
n=135, k=119, GF($2^m$)=GF($2^8$), t=2, and p=16.

36. The data encoding apparatus according to any one of claims 27 to 34, wherein a length of the codeword is n, the second FEC encoding is the extended BCH encoding over the finite field GF($2^m$) with t-bit error correction, the p parity bits comprise a cyclic redundancy check CRC extended check field of q bits, and a correspondence among n, k, GF($2^m$), t, p, and q is one of the following:

n=127, k=119, GF($2^m$)= GF($2^6$), t=1, p=8, and q=2;
n=128, k=119, GF($2^m$)= GF($2^7$), t=1, p=9, and q=2;
n=132, k=119, GF($2^m$)= GF($2^6$), t=2, p=13, and q=1;
n=133, k=119, GF($2^m$)= GF($2^6$), t=2, p=14, and q=2;
n=134, k=119, GF($2^m$)= GF($2^7$), t=2, p=15, and q=1;
n=135, k=119, GF($2^m$)= GF($2^7$), t=2, p=16, and q=2;
n=136, k=119, GF($2^m$)= GF($2^8$), t=2, p=17, and q=1; and
n=137, k=119, GF($2^m$)= GF($2^8$), t=2, p=18, and q=2.

37. A chip, wherein the chip comprises a processor and a memory, the memory and the processor are connected to each other through a line, the memory stores instructions, and the processor is configured to perform the method according to any one of claims 1 to 18.

| Transmitter device 01 | Attachment unit interface AUI | Transmitter processing module 02 | Channel transmission medium 03 | Receiver processing module 04 | Attachment unit interface AUI | Receiver device 05 |

FIG. 1

| Source | → | Transmitter data processing | → | Transmitter signal processing | → | Channel |
|---|---|---|---|---|---|---|

| Sink | ← | Receiver data processing | ← | Receiver signal processing | ← |  |

FIG. 2

Obtain consecutive k bits in a first data stream obtained through first FEC encoding — 101

Perform an exclusive OR operation on every s bits in the consecutive k bits of the first data stream to obtain a to-be-encoded sequence — 102

Perform second FEC encoding on the to-be-encoded sequence — 103

Perform symbol mapping and polarization distribution on a second data stream — 104

FIG. 3

Information sequence

FIG. 4(a)

Information sequence

FIG. 4(b)

Information sequence

FIG. 4(c)

FIG. 5

FIG. 6

FIG. 7

EP 4 776 540 A1

FIG. 8

FIG. 9

FIG. 10

EP 4 776 540 A1

EP 4 776 540 A1

FIG. 11

FIG. 12

EP 4 776 540 A1

Data encoding apparatus

Obtaining unit 201

Encoding unit 202

Mapping unit 203

FIG. 13

Data encoding apparatus

Processor 301

Transceiver 302

Memory 303

FIG. 14

## INTERNATIONAL SEARCH REPORT

| International application No. |
| --- |
| **PCT/CN2024/114145** |

**A.    CLASSIFICATION OF SUBJECT MATTER**

H04L1/00(2006.01)i

According to International Patent Classification (IPC) or to both national classification and IPC

**B.    FIELDS SEARCHED**

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

CNTXT, ENTXT, VEN, CNKI, 3GPP: 比特, 编码, 码字, 内码, 内码编码, 前向纠错, 校验, 比特, 异或, 子集, FEC, code word, inner code, coding, CRC

**C.    DOCUMENTS CONSIDERED TO BE RELEVANT**

| Category* | Citation of document, with indication, where appropriate, of the relevant passages | Relevant to claim No. |
| --- | --- | --- |
| A | CN 107026709 A (ZTE CORP.) 08 August 2017 (2017-08-08) description, paragraphs [0040]-[0045] | 1-37 |
| A | CN 108667553 A (HUAWEI TECHNOLOGIES CO., LTD.) 16 October 2018 (2018-10-16) entire document | 1-37 |
| A | CN 115622661 A (DATANG MOBILE COMMUNICATIONS EQUIPMENT CO., LTD.) 17 January 2023 (2023-01-17) entire document | 1-37 |
| A | CN 115037415 A (JIANGSU YIXIN AEROSPACE TECHNOLOGY CO., LTD.) 09 September 2022 (2022-09-09) entire document | 1-37 |
| A | WO 2016127820 A1 (ZTE CORP.) 18 August 2016 (2016-08-18) entire document | 1-37 |

☐ Further documents are listed in the continuation of Box C.    ☑ See patent family annex.

| | |
| --- | --- |
| *    Special categories of cited documents: | "T"   later document published after the international filing date or priority date and not in conflict with the application but cited to understand the principle or theory underlying the invention |
| "A"   document defining the general state of the art which is not considered to be of particular relevance | |
| "D"   document cited by the applicant in the international application | "X"   document of particular relevance; the claimed invention cannot be considered novel or cannot be considered to involve an inventive step when the document is taken alone |
| "E"   earlier application or patent but published on or after the international filing date | |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | "&"   document member of the same patent family |
| "P"   document published prior to the international filing date but later than the priority date claimed | |

| Date of the actual completion of the international search | Date of mailing of the international search report |
| --- | --- |
| **29 October 2024** | **18 November 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/114145**

| Patent document cited in search report | | | Publication date (day/month/year) | Patent family member(s) | | | Publication date (day/month/year) |
|---|---|---|---|---|---|---|---|
| CN | 107026709 | A | 08 August 2017 | WO | 2017133580 | A1 | 10 August 2017 |
| CN | 108667553 | A | 16 October 2018 | EP | 3595208 | A1 | 15 January 2020 |
| | | | | EP | 3595208 | A4 | 18 March 2020 |
| | | | | WO | 2018177152 | A1 | 04 October 2018 |
| | | | | US | 2020021313 | A1 | 16 January 2020 |
| | | | | US | 11043975 | B2 | 22 June 2021 |
| CN | 115622661 | A | 17 January 2023 | None | | | |
| CN | 115037415 | A | 09 September 2022 | None | | | |
| WO | 2016127820 | A1 | 18 August 2016 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311295101